# EUROPEAN PATENT APPLICATION

(11) **EP 3 527 716 A1**
(43) Date of publication of application: **21.08.2019**
(21) Application number: 18156873.4
(22) Date of filing: 15.02.2018
(51) Int. Cl.: D06F 75/38

(54) **IRONING APPARATUS, IRONING SYSTEM, AND METHOD OF OPERATING AN IRONING APPARATUS**

(71) Applicant: Vestel Elektronik Sanayi ve Ticaret A.S., 45030 Manisa (TR)
(72) Inventor: Demir, Murat, 45030 Manisa (TR); Kahramanoglu, Gürmen, 45030 Manisa (TR)
(74) Representative: Maikowski & Ninnemann Patentanwälte Partnerschaft mbB

(57) **Abstract**

The present disclosure relates to an ironing apparatus (100). The ironing apparatus (100) includes a body (110) having a gripping handle (112), an ironing plate (120) mounted to the body (110), and at least one presence sensor (130) at the ironing plate (120) and configured to detect an object (10) approaching the ironing plate (120).

## Description

### FIELD

Embodiments of the present disclosure relate to an ironing apparatus, an ironing system having the ironing apparatus, and a method of operating an ironing apparatus. The embodiments of the present disclosure particularly relate to a protection mechanism for an ironing apparatus.

### BACKGROUND

The iron is one of the most frequently used devices in households. If not used carefully, irons can cause severe injuries. For example, people can get burned when the hot ironing plate is touched. This applies especially to young children who may not know that the ironing plate is hot. Accordingly, there is a desire to prevent injuries caused by hot irons.

In view of the above, new ironing apparatuses, ironing systems, and methods of operating an ironing apparatus, that overcome at least some of the problems in the art are beneficial and it is an object of the present disclosure to provide an improved protection mechanism for an ironing apparatus.

### SUMMARY

In light of the above, an ironing apparatus, an ironing system having the ironing apparatus, and a method of operating an ironing apparatus are provided. Further aspects, benefits, and features of the present disclosure are apparent from the claims, the description, and the accompanying drawings.

According to an aspect of the present disclosure, an ironing apparatus is provided. The ironing apparatus includes a body having a gripping handle, an ironing plate mounted to the body, and at least one presence sensor at the ironing plate and configured to detect an object approaching the ironing plate.

According to a further aspect of the present disclosure, an ironing system is provided. The ironing system includes the ironing apparatus of the present disclosure and an ironing board.

According to another aspect of the present disclosure, a method of operating an ironing apparatus is provided. The method includes detecting a distance between an object approaching an ironing plate of the ironing apparatus, and providing a warning signal to a user if the detected distance is less than a set distance.

Embodiments are also directed at apparatuses for carrying out the disclosed methods and include apparatus parts for performing each described method aspect. These method aspects may be performed by way of hardware components, a computer programmed by appropriate software, by any combination of the two or in any other manner. Furthermore, embodiments according to the disclosure are also directed at methods for operating the described apparatus. The methods include method aspects for carrying out every function of the apparatus.

### BRIEF DESCRIPTION OF THE DRAWINGS

So that the manner in which the above recited features of the present disclosure can be understood in detail, a more particular description of the disclosure, briefly summarized above, may be had by reference to embodiments. The accompanying drawings relate to embodiments of the disclosure and are described in the following:
- FIG. 1: shows a schematic view of an ironing apparatus according to embodiments described herein;
- FIG. 2: shows a schematic view of an ironing apparatus according to further embodiments described herein;
- FIG. 3: shows a schematic view of an ironing system having an ironing apparatus and an ironing board according to embodiments described herein; and
- FIG. 4: shows a flow chart of a method of operating an ironing apparatus according to embodiments described herein.

### DETAILED DESCRIPTION OF EMBODIMENTS

Reference will now be made in detail to the various embodiments of the disclosure, one or more examples of which are illustrated in the figures. Within the following description of the drawings, the same reference numbers refer to same components. Generally, only the differences with respect to individual embodiments are described. Each example is provided by way of explanation of the disclosure and is not meant as a limitation of the disclosure. Further, features illustrated or described as part of one embodiment can be used on or in conjunction with other embodiments to yield yet a further embodiment. It is intended that the description includes such modifications and variations.

During ironing, a temperature of the ironing plate is high, e.g. more than 220°C. If the ironing plate is touched by a person, either accidentally or because the person does not know that the bottom of the iron is hot, severe burns may occur. The present disclosure uses a presence sensor at the ironing plate to detect an object, such as a person's hand, within a set distance from the ironing plate. If the object comes too close to the hot ironing plate, a warning signal may be generated to keep the person from touching the hot ironing plate. Accordingly, an improved protection mechanism can be provided.

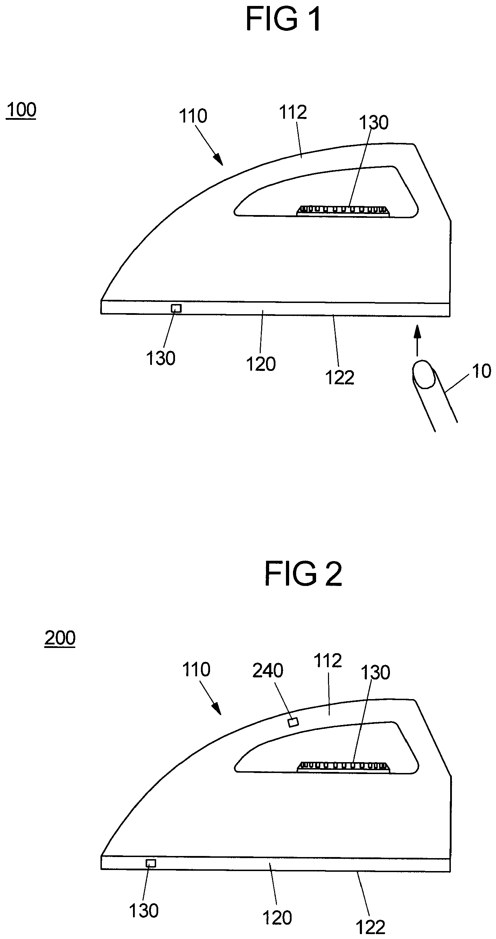

FIG. 1 shows a schematic view of an ironing apparatus 100 according to embodiments described herein. The ironing apparatus 100 can also be referred to as "iron".

The ironing apparatus 100 includes a body 110 or housing having a gripping handle 112, an ironing plate 120 (also referred to as "soleplate" or "base") mounted to the body 110, and at least one presence sensor 130 at the ironing plate 120 and configured to detect an object 10 approaching the ironing plate 120. For example, the at least one presence sensor 130 can be configured to detect the object within a set distance from the at least one presence sensor 130, and in particular from the ironing plate 120.

The ironing apparatus 100 may include a heater (not shown) configured to heat the ironing plate 120 to a set temperature. The temperature can be set using for instance a temperature control knob 130. The heater can be installed in the body 110. In some embodiments, the heater can be an electric resistance heater which may include one or more wire-like resistors. However, the present disclosure is not limited thereto and other means for heating the ironing plate 120 can be used. The ironing plate 120 has an ironing surface 122. The ironing plate 120 and the ironing surface 122 can be boat-shaped.

According to some embodiments, which can be combined with other embodiments described herein, the at least one presence sensor 130 is a distance sensor or a proximity sensor. The proximity sensor may emit an electromagnetic field or a beam of electromagnetic radiation, such as infrared radiation, and detect changes in the field or return signal.

The at least one presence sensor 130 can be configured to detect the presence of an object within a set distance from the ironing apparatus 100, and in particular from the ironing plate 120. The set distance can define a safety zone around the ironing plate 120. If it is determined that an object enters the safety zone, a warning signal can be issued to the surrounding environment to keep a person from touching the ironing plate 120.

The at least one presence sensor 130 can have a nominal range which indicates the maximum distance the sensor can detect an object. The set distance can be less than the nominal range. The set distance can be selected such that there is enough time for the user to react to a warning signal to avoid a contact with the hot ironing plate 110.

In some implementations, the ironing apparatus 100 can include a controller (not shown) configured to emit the warning signal if the at least one presence sensor 130 detects the object 10 within the set distance. In other words, the controller may emit the warning signal if the object 10, such as a person's hand or finger, is detected in the safety zone around the ironing plate 120.

In some implementations, the warning signal includes at least one of an audio signal, a visual signal, and a haptic signal. For example, the ironing apparatus 100 may include a loudspeaker to provide the audio signal, which may be a loud sound such as a beep, in order to notify the user about an imminent burn. Optionally or alternatively, the ironing apparatus 100 may include an optical device such as one or more lights (e.g. LEDs) to provide the visual signal. Optionally or alternatively, the ironing apparatus 100 may include a haptic device e.g. in the gripping handle 112 to provide the haptic signal to a user gripping the gripping handle 112. The haptic signal may be a vibration.

According to some embodiments, which can be combined with other embodiments described herein, the at least one presence sensor 130 is arranged on or in the ironing plate 110, or at an essentially same plane as the ironing plate 110. In the example of FIG. 1, the at least one presence sensor 130 is arranged in the ironing plate 110. The at least one presence sensor 130 can be thermally insulated from its surroundings, and in particular from the ironing plate 110. In a further example, the at least one presence sensor 130 can be arranged in an essentially same plane as the ironing plate 110. For instance, the at least one presence sensor 130 can be mounted to the body 110 to be at the essentially same plane as the ironing plate 110, and in particular at the essentially same plane as the ironing surface 122.

However, the present disclosure is not limited thereto and the at least one presence sensor 130 can be arranged at any location on (or in) the ironing apparatus 100 which is suitable for the monitoring of the surroundings of the ironing plate 110. In some embodiments, the at least one presence sensor 130 can be located such that the at least one presence sensor 130 can monitor (the surroundings of) essentially the entire ironing plate 110.

In some implementations, the at least one presence sensor 130 can be one single presence sensor or can be a plurality of presence sensors. For example, the plurality of presence sensors can be distributed across the ironing plate 110 or a periphery of the ironing plate 110 such that the plurality of presence sensors can monitor the surroundings of the entire ironing plate 110.

FIG. 2 shows a schematic view of an ironing apparatus 200 according to further embodiments described herein. The ironing apparatus 200 of FIG. 2 is similar to the ironing apparatus of FIG. 1, and a description of similar or identical elements is not repeated.

According to some embodiments, which can be combined with other embodiments described herein, the ironing apparatus 200 includes at least one first contact sensor 240 at the gripping handle 112. In some implementations, the at least one first contact sensor 240 can be a capacitive sensor. However, the present disclosure is not limited thereto and the at least one first contact sensor 240 can be another sensor suitable to detect a contact between the sensor or the gripping handle 112 and an external object, such as a user's hand.

The at least one first contact sensor 240 can be integrated in the gripping handle 112 or can be mounted on the gripping handle 112. The at least one first contact sensor 240 is configured to detect whether a user contacts, e.g. grips or holds, the gripping handle 112 or not. In some implementations, the at least one first contact sensor 240 can be one single contact sensor or can be a plurality of contact sensors. For example, the plurality of contact sensors can be distributed along the gripping handle 112 such that the plurality of contact sensors can reliably detect whether the user is gripping the gripping handle 112 or not.

According to some embodiments, the at least one presence sensor 130 and the at least one first contact sensor 240 communicate with each other and/or the controller. The communication can be wireless or wire-based. For example, the controller is configured to emit the warning signal if the at least one presence sensor 130 detects the object in the safety zone and the at least one first contact sensor 240 provides a positive detection signal indicating that a user is gripping the gripping handle 112.

In some implementations, the at least one presence sensor 130 is configured to output a positive detection signal, such as a binary "I", and a negative detection signal, such as a binary "0". The positive detection signal can be output if an object is detected within the set distance, i.e., within the safety zone. The negative detection signal can be output if there is no object within the set distance, i.e., the safety zone is clear.

Optionally or alternatively, the at least one first contact sensor 240 can be configured to output a positive detection signal, such as a binary "1", and a negative detection signal, such as a binary "0". The positive detection signal can be output if a contact is detected, i.e., if the user grips the gripping handle 112. The negative detection signal can be output if there is no contact, i.e., when no one grips the gripping handle 112.

The controller can be configured to output the warning signal if both detection signals are positive, i.e., if the at least one presence sensor 130 outputs the positive detection signal, such as the binary "1", and the at least one first contact sensor 240 too outputs the positive detection signal, such as the binary "1". If one or both sensors output the negative detection signal, such as the binary "0", no warning signal is issued. In some implementations, the ironing apparatus 200 can include a switch to enable and disable this protection mechanism.

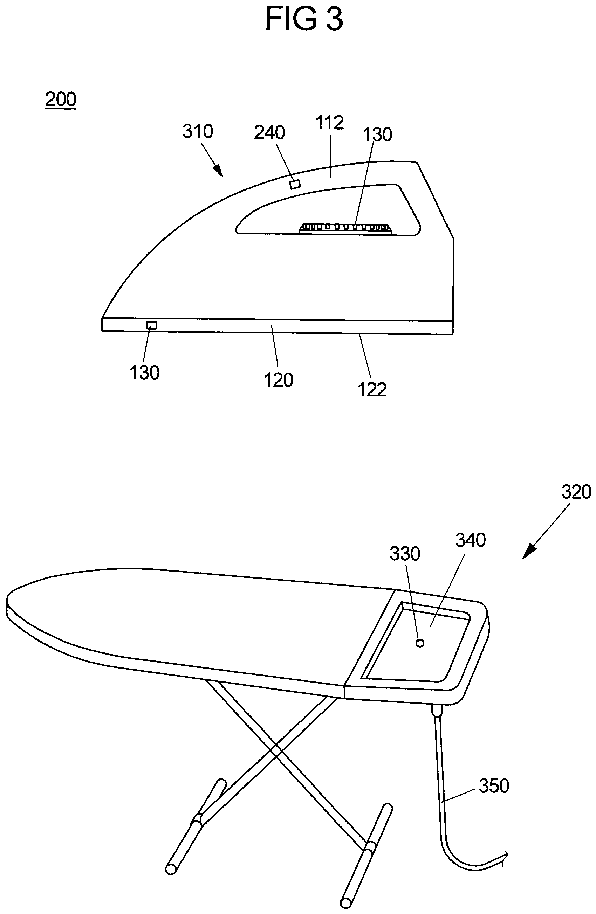

FIG. 3 shows a schematic view of an ironing system 300 having an ironing apparatus 310 and an ironing board 320 according to embodiments described herein. The ironing apparatus 310 can be configured as described with reference to FIG. 2.

According to some embodiments, the ironing system 300 includes at least one second contact sensor 330 at the ironing board 320. For example, the ironing board 320 may include a safety slot 340 for the ironing apparatus 310 and the at least one second contact sensor 330 can be arranged at the safety slot 340. In the example illustrated in FIG. 3, the at least one second contact sensor 330 can be arranged at a center portion of the safety slot 340.

The at least one second contact sensor 330 can be configured to detect whether the ironing apparatus 310 is in the safety slot 340 or not. In some implementations, the at least one second contact sensor 330 can be a capacitive sensor. However, the present disclosure is not limited thereto and the at least one second contact sensor 330 can be another sensor suitable to detect a contact between the sensor or the safety slot 340 and the ironing apparatus 310.

According to some embodiments, the at least one second contact sensor 330 can be one single contact sensor or can be a plurality of contact sensors. For example, the plurality of contact sensors can be distributed across the safety slot 340 such that the plurality of contact sensors can reliably detect whether the ironing apparatus 310 is there or not.

In the example illustrated in FIG. 3, two sensors are placed on the ironing apparatus 310. One of the sensors is on the iron holder, i.e., the gripping handle 112, one of the sensors is on the base of the iron or on the same plane with the base, and the other sensor is on the ironing table 320. The sensors can intermittently or continuously communicate with each other and/or with the controller of the ironing apparatus 310. The ironing system 300, and in particular the ironing station 320, may for instance include a communication unit configured to communicate detection signals provided by the at least one second contact sensor 330 to the ironing apparatus 310. The ironing apparatus 310 may include a further communication unit configured to receive the detection signals from the communication unit of the ironing station 320. The ironing station 320 may include a power supply, such as a cable 350, to provide the at least one second contact sensor 330 and/or the communication unit with power.

According to some embodiments, the at least one second contact sensor 330 can be configured to output a positive detection signal, such as a binary "1", and a negative detection signal, such as a binary "0". The positive detection signal can be output if a contact is detected, i.e., when the ironing apparatus 310 is in the safety slot 340. The negative detection signal can be output if there is no contact, i.e., when the ironing apparatus 310 is not in the safety slot 340. In some implementations, the communication unit of the ironing apparatus 310 may receive the negative detection signal from the at least one second contact sensor / the communication unit of the ironing board 320 when the ironing apparatus 310 is not placed in the safety slot 340.

The controller can be configured to output the warning signal if the detection signals of both the at least one presence sensor 130 and the at least one first contact sensor 240 are positive and if the detection signal of the at least one second contact sensor 330 is negative. For example, a sound with a high amplitude can be output and the user can be notified about the imminent danger. If one or both sensors of the at least one presence sensor 130 and the at least one first contact sensor 240 output the negative detection signal and/or the at least one second contact sensor 330 outputs the positive detection signal, no warning signal is output. In particular, there is no danger imminent when the ironing apparatus 310 is in the safety slot 340.

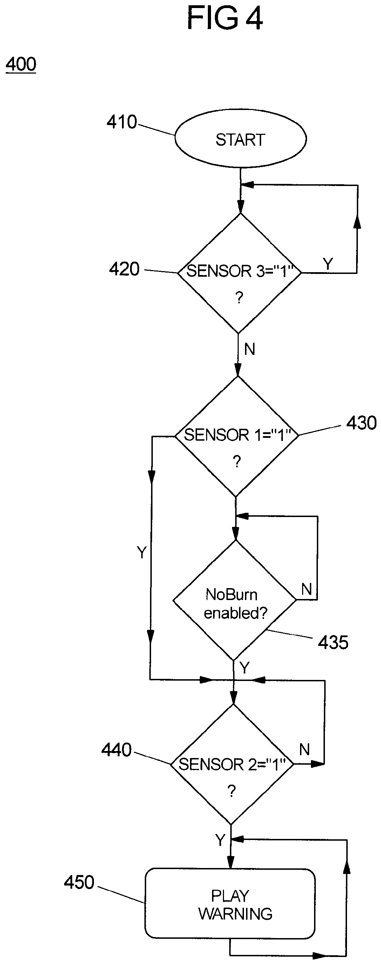

FIG. 4 shows a flow chart of a method 400 of operating an ironing apparatus according to embodiments described herein.

The method 400 may utilize the ironing apparatus and the ironing system according to the present disclosure. Likewise, the ironing apparatus and the ironing system can implement the method 400. In some implementations, the method 400 can be implemented in the form of an algorithm, which may be executed by the controller of the ironing apparatus.

The method of operating an ironing apparatus includes detecting a distance between an object approaching an ironing plate of the ironing apparatus and providing a warning signal to a user if the detected distance is less than a set distance. The warning signal may be provided if (i) the detected distance is equal to or less than the set distance, and (ii) if the user holds the ironing apparatus and/or the ironing apparatus is not positioned in a safety slot of an ironing board. According to some embodiments, the warning signal is only output if the user has activated a safety function of the ironing apparatus.

In some implementations, it can be detected that the user holds the ironing apparatus when a contact between the user's hand and a gripping handle of the ironing apparatus is detected. Optionally or alternatively, it can be detected that the ironing apparatus is not positioned in the safety slot of the ironing board if no contact between the ironing apparatus and the safety slot is detected.

Turning now to the flowchart of FIG. 4, the exemplary algorithm starts at block 410 and proceeds to block 420 where it is determined whether the ironing apparatus is in the safety slot. If it is determined that the ironing apparatus is in the safety slot, e.g., if the at least one second contact sensor ("Sensor 3") outputs a positive detection signal ("1"), the algorithm starts from the beginning. If it is determined that the ironing apparatus is not in the safety slot, e.g., if the at least one second contact sensor outputs a negative detection signal ("0"), the algorithm proceeds to block 430.

In block 430 it is determined whether the user grips the gripping handle. If it is determined that the user does not contact the gripping handle, e.g., if the at least one first contact sensor ("Sensor 1") outputs a negative detection signal ("0"), the algorithm may start from the beginning. If it is determined that the user contacts the gripping handle, e.g., if the at least one first contact sensor outputs a positive detection signal ("1"), the algorithm proceeds to block 440, either directly or via a further block 435 to be described later.

In block 440 it is determined whether an object, such as a user's hand, is within the set distance, i.e., the safety zone. If it is determined that there is an object in the safety zone, e.g., if the at least one presence sensor ("Sensor 2") outputs a positive detection signal ("1"), the algorithm proceeds to block 450. If it is determined that the safety zone is clear, e.g., if the at least one presence sensor outputs a negative detection signal ("0"), the algorithm either starts at the beginning or repeats at least block 440.

If it is determined in block 440 that there is an object in the safety zone, the warning signal is output in block 450. The warning signal can include at least one of an audio signal, a visual signal, and a haptic signal. For example, the audio signal may be a loud sound such as a beep. The visual signal may be a flashing light, such as a flashing LED. The haptic signal may be a vibration e.g. of the gripping handle.

If the warning signal is output in step 450, the algorithm may once or repeatedly check whether still all conditions of blocks 420, 430, and 440 are satisfied, i.e., whether the user still contacts the gripping handle, whether the ironing apparatus is still not placed in the safety slot, and whether the object is still in the safety zone. If one of these conditions is not satisfied anymore, the output of the warning signal can be stopped and the method can start from the beginning.

In some implementations, the method 400 may check at block 435 whether the safety function is enabled. The warning signal may be output only if the safety function is enabled. If the safety function is not enabled, no warning signal is output. The user may enable and disable the safety function using for instance a switch at the ironing apparatus.

Although block 435 is exemplarily illustrated between blocks 430 and 440, it is to be understood that the present disclosure is not limited thereto and that block 435 can be provided earlier or later in the process flow. For example, block 435 can be provided between blocks 410 and 420 at the beginning of the algorithm.

According to embodiments described herein, the method of operating the ironing apparatus can be conducted by means of computer programs, software, computer software products and the interrelated controllers, which can have a CPU, a memory, a user interface, and input and output means being in communication with the corresponding components of the ironing apparatus and/or the ironing system.

During ironing, a temperature of the ironing plate is high, e.g. more than 220°C. If the ironing plate is touched by a person, either accidentally or because the person does not know that the bottom of the iron is hot, severe burns may occur. The present disclosure uses a presence sensor at the ironing plate to detect an object, such as a person's hand, within a set distance from the ironing plate. If the object comes too close to the hot ironing plate, a warning signal may be generated to keep the person from touching the hot ironing plate. Accordingly, an improved protection mechanism can be provided.

While the foregoing is directed to embodiments of the disclosure, other and further embodiments of the disclosure may be devised without departing from the basic scope thereof, and the scope thereof is determined by the claims that follow.

## Claims

1. An ironing apparatus (100, 200, 310), comprising:
a body (110) having a gripping handle (112);
an ironing plate (120) mounted to the body (110); and
at least one presence sensor (130) at the ironing plate (120) and configured to detect an object (10) approaching the ironing plate (120).

2. The ironing apparatus (200, 310) of claim 1, further including at least one first contact sensor (240) at the gripping handle (112).

3. The ironing apparatus (100, 200, 310) of claim 1 or 2, wherein the at least one presence sensor (130) is a distance sensor or a proximity sensor.

4. The ironing apparatus (100, 200, 310) of any one of claims 1 to 3, wherein the at least one presence sensor (130) is arranged on or in the ironing plate (120), or at an essentially same plane as the ironing plate (120).

5. The ironing apparatus (310) of any one of claims 1 to 4, further including a communication unit configured to receive detection signals from at least one second contact sensor (330) at an ironing station (320).

6. The ironing apparatus (100, 200, 310) of any one of claims 1 to 5, further including a controller configured to output a warning signal if the at least one presence sensor (130) detects the object (10) within a set distance.

7. The ironing apparatus (310) of claim 6, wherein the controller is configured to emit the warning signal if the at least one presence sensor (130) detects the object (10) within the set distance and one or more of the following conditions apply:
a) the at least one first contact sensor (240) provides a positive detection signal indicating that a user is gripping the gripping handle (112); and
b) the communication unit receives a negative detection signal from the at least one second contact sensor (330) indicating that the ironing apparatus (310) is not placed in a safety slot (340) of the ironing board (320).

8. The ironing apparatus (100, 200, 310) of claim 6 or 7, wherein the warning signal includes at least one of an audio signal, a visual signal, and a haptic signal.

9. An ironing system (300), comprising:
the ironing apparatus (310) of any one of claims 1 to 8; and
an ironing board (320).

10. The ironing system (300) of claim 9, further including;
at least one second contact sensor (330) at the ironing board (320); and
a communication unit configured to communicate detection signals provided by the at least one second contact sensor (330) to the ironing apparatus (310).

11. The ironing system (300) of claim 10, wherein the ironing board (320) includes a safety slot (340) configured to accommodate the ironing apparatus (310), and wherein the at least one second contact sensor (330) is arranged at, or in, the safety slot (340).

12. A method (400) of operating an ironing apparatus, comprising:
detecting (440) a distance between an object approaching an ironing plate of the ironing apparatus; and
providing (450) a warning signal to a user if the detected distance is less than a set distance.

13. The method (400) of claim 12, wherein the warning signal is provided if the detected distance is less than the set distance and one or more of the following additional conditions apply:
a) it is detected that a user holds the ironing apparatus (430); and
b) it is detected that the ironing apparatus is not positioned in a safety slot of an ironing board (420).

14. The method (400) of claim 13, wherein it is detected that the user holds the ironing apparatus when a contact between the user's hand and a gripping handle of the ironing apparatus is detected, and/or wherein it is detected that the ironing apparatus is not positioned in the safety slot of the ironing board when no contact between the ironing apparatus and the safety slot is detected.

15. The method (400) of any one of claims 12 to 14, further including:
providing (450) the warning signal to the user if the detected distance is less than the set distance and a safety function of the ironing apparatus is activated.
